# EUROPEAN PATENT APPLICATION

(11) **EP 2 720 278 A1**
(43) Date of publication of application: **16.04.2014**
(21) Application number: 12797554.8
(22) Date of filing: 30.05.2012
(51) Int. Cl.: H01L 31/042

(54) **SOLAR CELL MODULE MANUFACTURING METHOD**

(30) Priority: 09.06.2011 JP 2011128887
(71) Applicant: Bridgestone Corporation, Tokyo 104-8340 (JP)
(72) Inventor: KATAOKA Hisataka, Yokohama-shi Kanagawa 244-8510 (JP); TOMIYAMA Makiko, Yokohama-shi Kanagawa 244-8510 (JP); INOUE Yoshihiko, Yokohama-shi Kanagawa 244-8510 (JP)
(74) Representative: Waldren, Robin Michael
(86) International application number: PCT/JP2012/063900
(87) International publication number: WO 2012/169399

(57) **Abstract**

To provide a process for manufacturing a solar cell module capable of preventing a backside colored sealing film from wrapping around to the light-receiving side of photovoltaic elements. The process for manufacturing a solar cell module of the present invention includes superposing a light-receiving side transparent protection material 11, a light-receiving side sealing film 13A, photovoltaic elements 14, a backside colored sealing film 13B and a backside protection material 12 in this order to give a stack 10, and applying heat and pressure to the stack 10 to integrate it, wherein the light-receiving side sealing film 13A has a thickness less than that of the backside colored sealing film 13B.

## Description

### Technical Field

The present invention relates to a process for manufacturing a solar cell module, particularly to a process for manufacturing a solar cell module capable of preventing wraparound of a backside colored sealing film.

### Background Art

In recent years, a solar cell module has been widely employed as a device directly converting solar energy into electric energy from the viewpoints of the effective use of natural resources and the prevention of environmental pollution. The development of the solar cell module is being carried out.

A solar cell module generally has a structure that photovoltaic elements are sealed by a light-receiving side sealing film and a backside sealing film which are arranged between a light-receiving side transparent protection material and a backside protection material (back cover). Such a conventional solar cell module has a plurality of photovoltaic elements connected with each other in order to obtain high generating output. Thus, to ensure insulation properties between photovoltaic elements, sealing films having high insulation properties are used.

In general, films made of ethylene-vinyl acetate copolymer (EVA) or the like have been preferably used as the light-receiving side and backside sealing films. In order to enhance film strength and durability, the cross-linking density of the sealing film is improved by using a crosslinker such as an organic peroxide.

It is strongly desired to introduce sunlight incident to the solar cell module into photovoltaic elements as efficiently as possible in view of power generation efficiency. Thus, preferred is a light-receiving side sealing film that neither absorbs nor reflects sunlight but is capable of transmitting most sunlight. Therefore, a sealing film having excellent transparency has been used as the light-receiving side sealing film so far (for example, Patent Document 1).

As the backside sealing film, an EVA film colored by a colorant such as titanium dioxide (TiO₂) has been used (for example, Patent Document 2). The use of a colored backside sealing film makes it possible to introduce sunlight incident between photovoltaic elements into the back side of the photovoltaic elements by reflection of the sunlight at the boundary between a light-receiving side sealing film and the backside sealing film and by diffuse reflection by the colorant itself. This enhances the use efficiency of sunlight incident to a solar cell module, and thus improves power generation efficiency.

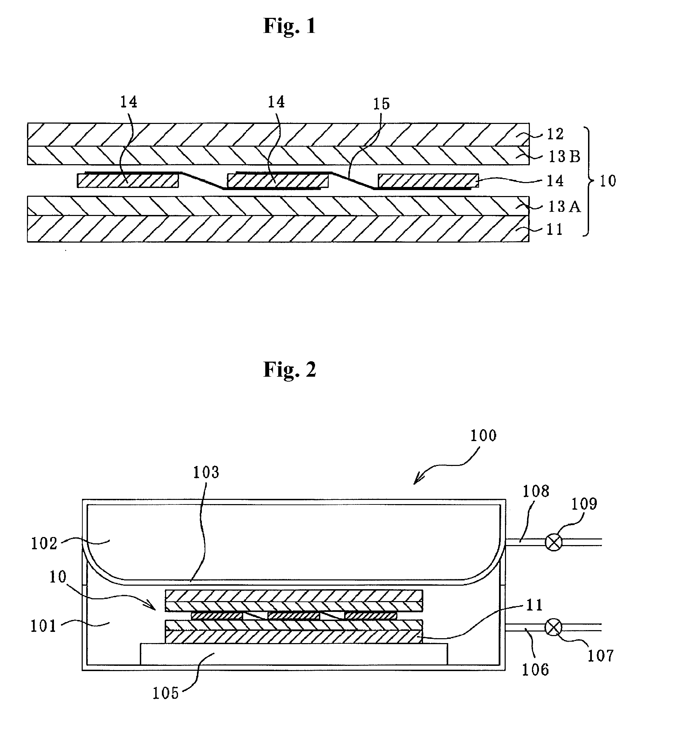

As shown in Fig. 1, in order to produce a solar cell module, a light-receiving side transparent protection material 11, a light-receiving side sealing film 13A, a plurality of photovoltaic elements 14 electrically connected by connection tabs 15, a backside sealing film 13B and a backside protection material (back cover) 12 are superposed in this order to give a stack 10, and the stack 10 is heated and pressurized, whereby the light-receiving side sealing film 13A and the backside sealing film 13B are cross-linked and cured, and thus they are bonded and integrated.

The bonding and integrating of the components of the stack 10 are generally carried out by using a vacuum laminator. As the vacuum laminator, for example, a double vacuum chamber-type laminator having an upper chamber 102 provided with a diaphragm 103 and a lower chamber 101 provided with a placement base 105 is used, as shown in Fig. 2. The bonding and integrating are carried out by placing the stack 10 on the placement base 105 such that the light-receiving side transparent protection material 11 is located on the lower side, evacuating the upper side chamber 102 and the lower chamber 101, and heating the stack 10 by a heater (not illustrated) embedded in the placement base 105 with pressing the top side of the stack 10 by allowing the pressure in the upper chamber 102 to rise to atmospheric pressure or higher using the diaphragm 103.

### Prior Art Documents

### Patent Document

Patent Document 1: JP (TOKKAI) 2008-053379 A
Patent Document 2: JP (TOKKAI) H06-177412 A

### Summary of the Invention

### Problem to be Solved by the Invention

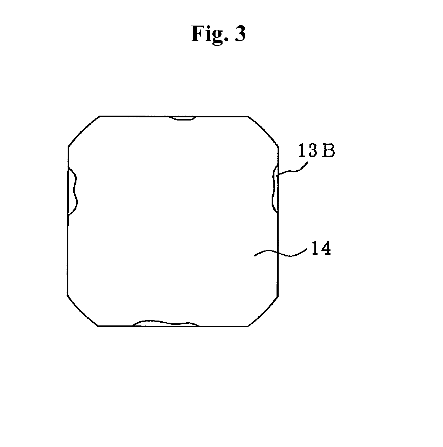

However, when pressure is applied to the stack, the pressure to the stack may be non-uniformly distributed. Thus, the backside colored sealing film 13B melted by heating may enter onto the light-receiving side of the photovoltaic element 14 (this phenomenon is hereinafter referred to as "wraparound"), as shown in Fig. 3. The occurrence of the wraparound brings about not only poor appearance of the solar cell module, but also reduction of the amount of sunlight incident to photovoltaic elements, whereby the power generation efficiency may be reduced.

It is therefore an object of the present invention is to provide a process for manufacturing a solar cell module capable of preventing a backside colored sealing film from wrapping around to the light-receiving side of photovoltaic elements.

### Means for Solving Problem

The object can be achieved by a process for manufacturing a solar cell module, comprising superposing a light-receiving side transparent protection material, a light-receiving side sealing film, photovoltaic elements, a backside colored sealing film and a backside protection material in this order to give a stack, and applying heat and pressure to the stack to integrate it, wherein the light-receiving side sealing film has a thickness less than that of the backside colored sealing film.

It is considered that the wraparound is caused by the phenomenon that pressurizing force is concentrated on the edge of the stack and as a result, the edge is not pressurized vertically but is pressurized with the edge inclined inward. The use of the thicker backside colored sealing film leads to reduced non-uniformity of the pressurizing force, whereby the whole top side of the stack can be pressurized at a uniform pressure without concentration of the pressure on the edge. In addition, the use of the thinner light-receiving side sealing film results in good heat transfer to the whole light-receiving side sealing film, thereby improving adhesion of the melted light-receiving side sealing film to photovoltaic elements. Furthermore, since the use of the backside colored sealing film thicker than the light-receiving side sealing film results in slower heat transfer to the whole backside colored sealing film than that of the light-receiving side sealing film thereby delaying melting of the backside colored sealing film, the entrance of the backside colored sealing film onto the light-receiving side of the photovoltaic elements can be prevented.

The preferred embodiments of the present invention are as follows:
(1) The light-receiving side sealing film has a thickness of 0.3 to 0.55 mm.
(2) The backside colored sealing film has a thickness of 0.55 to 1.2 mm.
(3) A ratio of the thickness of the backside colored sealing film to that of the light-receiving side sealing film is in the range of 1.25 to 3.00.
(4) Heat is applied to the side of the light-receiving side transparent protection material.
(5) The stack is heated to a temperature in the range of 80 to 150°C.
(6) Pressure of 1.0×10³ Pa to 5.0×10⁷ Pa is applied to the stack.
(7) The light-receiving side sealing film and the backside colored sealing film each comprise ethylene-vinyl acetate copolymer and a crosslinker.
(8) The backside colored sealing film comprises a colorant selected from the group consisting of titanium dioxide, calcium carbonate, ultramarine and carbon black.

The present invention also provide a solar cell module obtained by arranging sealing films between a light-receiving side transparent protection material and a backside protection material and bonding and integrating them to seal photovoltaic elements, wherein a light-receiving side sealing film arranged between the photovoltaic elements and the light-receiving side transparent protection material has a thickness less than that of a backside colored sealing film arranged between the photovoltaic elements, and the backside protection material.

### Effect of the Invention

The process for manufacturing a solar cell module of the present invention is capable of preventing a backside colored sealing film from wrapping around to the light-receiving side of photovoltaic elements. Thus, solar cell modules which are prevented from reduction in appearance and power generation efficiency can be obtained.

### Brief Description of the Drawings

Fig. 1 is a schematic sectional view of a solar cell module.
Fig. 2 is a schematic sectional view of a general vacuum laminator.
Fig. 3 is a view for explaining a condition of wraparound.

### Description of Embodiments

As shown in Fig. 1, the process for manufacturing a solar cell module of the present invention comprises superposing a light-receiving side transparent protection material 11, a light-receiving side sealing film 13A, photovoltaic elements 14, a backside colored sealing film 13B and a backside protection material 12 in this order to give a stack 10, and applying heat and pressure to the stack 10 to integrate it. In general, a plurality of photovoltaic elements 14 are electrically connected with each other by connection tabs 15 composed of a conductive material such as a copper foil. The dimensional ratios of the individual components shown in Fig. 1 which is a schematic view do not necessarily correspond to actual dimensional ratios. In the present invention, the side (front side) which is exposed to light for photovoltaic elements is referred to as "light-receiving side", while the side opposite to the light-receiving side of photovoltaic elements is referred to as "backside".

The individual components of the solar cell module are explained below.

### [Light-receiving side sealing film and Backside colored sealing film]

As described above, in the present invention, the light-receiving side sealing film has a thickness less than that of the backside colored sealing film. Specifically, the light-receiving side sealing film preferably has a thickness of 0.3 to 0.55 mm. The backside colored sealing film preferably has a thickness of 0.55 to 1.2 mm. These ranges result in preventing the wraparound reliably. When a sealing film having a thickness of 0.55 mm is used as the light-receiving side sealing film, a sealing film having a thickness of more than 0.55 mm is used as the backside colored sealing film.

The ratio of the thickness of the backside colored sealing film to that of the light-receiving side sealing film (the backside colored sealing film / the light-receiving side sealing film) is preferably in the range of 1.25 to 3.00, in particular 1.60 to 3.00.

The difference between the thickness of the backside colored sealing film and that of the light-receiving side sealing film (i.e. the thickness of the backside colored sealing film minus the thickness of the light-receiving side sealing film) is preferably in the range of 0.2 to 0.9 mm, particularly in the range of 0.5 to 0.9 mm.

As the light-receiving side sealing film and the backside colored sealing film, sealing films prepared using ethylene-vinyl acetate copolymer (EVA) are preferably used. The use of ethylene-vinyl acetate copolymer can give sealing films which are inexpensive and excellent in insulation and flexibility.

The content of vinyl acetate in ethylene-vinyl acetate copolymer is preferably in the range of 20 to 35% by weight, more preferably 22 to 30% by weight, particularly 24 to 28% by weight, based on the weight of ethylene-vinyl acetate copolymer. When the content is less than 20% by weight, the flowability of a composition for sealing films may be reduced and thus the processability may be reduced. When the content is more than 35% by weight, the EVA is apt to form carboxylic acids, alcohols or amines to generate bubbles at the interface between the sealing films and the components adjacent to the sealing films.

The light-receiving side sealing film and the backside colored sealing film may secondarily contain polyvinyl acetal resin such as polyvinyl formal, polyvinyl butyral (PVB resin) or modified PVB, or vinyl chloride resin, in addition to ethylene-vinyl acetate copolymer. The PVB resin is preferred.

The ethylene-vinyl acetate copolymer preferably has Melt Flow Rate according to JIS K 7210 of not more than 35 g/10 min., particularly 3 to 6 g/10 min. The use of a light-receiving side sealing film and backside colored sealing film made of the ethylene-vinyl acetate copolymer having Melt Flow Rate specified as above makes it possible to suppress the phenomenon that the sealing films spread out of a substrate due to their melt or position gap in a heating and pressurizing procedure of the sealing step for preparing a solar cell module. The value of the Melt Flow Rate (MFR) is determined under the conditions of temperature of 190°C and load of 21.18N according to JIS K 7210.

In the invention, the light-receiving side sealing film and the backside colored sealing film preferably contain a crosslinker for forming cross-linked structure of ethylene-vinyl acetate copolymer. An organic peroxide or photopolymerization initiator is preferably used as the crosslinker. The organic peroxide is more preferably used because the resultant sealing film is improved in temperature dependencies in adhesion, humidity resistance and penetration resistance.

Any organic peroxides that can be decomposed at a temperature of not less than 100°C to generate radical(s) can be employed as the organic peroxide. The organic peroxide is generally selected in the consideration of film-forming temperature, conditions for preparing the composition, curing (bonding) temperature, heat resistance of body to be bonded, storage stability. Especially, preferred are those having a decomposition temperature of not less than 70 °C in a half-life of 10 hours.

From the viewpoint of resin processing temperature and storage stability, examples of the organic peroxides include benzoyl peroxide-type cure agents, t-hexyl peroxypyvalate, t-butyl peroxypyvalate, 3,5,5-trimethyl hexanoyl peroxide, di-n-octanoyl peroxide, lauroyl peroxide, stearoyl peroxide, 1,1,3,3-tetramethylbutylperoxy-2-ethyl hexanoate, succinic acid peroxide, 2,5-dimethyl-2,5-di(t-butylperoxy)hexane, 2,5-dimethyl-2,5-di(2-ethylhaxanoylperoxy)hexane, 1-cyclohexyl-1-methylethylperoxy-2-ethyl hexanoate, t-hexylperoxy-2-ethyl hexanoate, 4-methylbenzoyl peroxide, t-butylperoxy-2-ethyl hexanoate, m-toluoyl+benzoyl peroxide, benzoyl peroxide, 1,1-bis(t-butylperoxy)-2-methylcyclohexanate, 1,1-bis(t-hexylperoxy)-3,3,5-trimethylcyclohexanate, 1,1-bis(t-hexylperoxy)cyclohexanate, 1,1-bis(t-butylperoxy)-3,3,5-trimethylcyclohexane, 1,1-bis(t-butylperoxy)cyclohexane, 2,2-bis(4,4-di-t-butylperoxycyclohexyl)propane, 1,1-bis(t-butylperoxy)cyclododecane, t-hexylperoxyisopropyl monocarbonate, t-butylperoxy maleic acid, t-butylperoxy-3,3,5-trimethyl hexane, t-butyl peroxylaurate, 2,5-dimethyl-2,5-di(methylbenzoylperoxy)hexane, t-butylperoxyisopropyl monocarbonate, t-butylperoxy-2-ethylhexyl monocarbonate, t-hexyl peroxybenzoate, and 2,5-dimethyl-2,5-di(benzoylperoxy)hexane.

As the benzoyl peroxide-type cure agents, any organic peroxides that can be decomposed at a temperature of not less than 70°C to generate radical(s) can be employed. Especially, preferred are those having a decomposition temperature of not less than 50°C in a half-life of 10 hours. The benzoyl peroxide-type cure agents is selected in the consideration of conditions for preparing the composition, film-forming temperature, curing (bonding) temperature, heat resistance of body to be bonded, storage stability. Examples of the benzoyl peroxide-type cure agents include benzoyl peroxide, 2,5-dimethylhexyl-2,5-bisperoxy benzoate, p-chlorobenzoyl peroxide, m-toluoyl peroxide, 2,4-dichlorobenzoyl peroxide, t-butylperoxy benzoate. The benzoyl peroxide-type cure agents can be employed singly or in combination of two or more kinds.

The organic peroxides are preferably 2,5-dimethyl-2,5-di(t-butylperoxy)hexane and 1,1-bis(t-hexylperoxy)-3,3,5-trimethylcyclohexane. These organic peroxide can give sealing films having high insulation properties.

The organic peroxide is contained in an amount of 0.1 to 5 parts by weight, preferably 0.2 to 3 parts by weight, based on 100 parts by weight of ethylene-vinyl acetate copolymer. If the content of the organic peroxide is smaller, insulation properties of the resultant sealing film may be reduced. If the content is excessive, compatibility with the copolymer is apt to be reduced.

As the photopolymerization initiators, any known photopolymerization initiators can be employed. Preferred are initiators having good storage stability after addition thereof. Examples of the photopolymerization initiators include acetophenone type initiators such as 2-hydroxy-2-methyl-1-phenylpropane-1-on, 1-hydroxycyclohexylphenylketone, 2-methyl-1-[4-(methylthio)phenyl]-2-morphorinopropane-1-on; benzoin type initiators such as benzylmethylketal; and benzophenone type initiators such as benzophenone, 4-phenylbenzophenone and hydroxybenzophenone; thioxanthone type initiators such as isopropylthioxanthone and 2,4-diethythioxanthone. Further, as special type, there can be mentioned methylphenylglyoxylate. Especially preferred are 2-hydroxy-2-methyl-1-phenylpropane-1-on, 1-hydroxycyclohexylphenylketone, 2-methyl-1-[4-(methylthio)phenyl]-2-morphorinopropane-1-on and benzophenone. These photopolymerization initiators can be employed, if necessary, together with one or more kinds of a photopolymerization promoter such as a benzoic acid type compound (e.g., 4-dimethylaminobezoic acid) or a tertiary amine compound by mixing the initiator with the promoter in optional ratio. The initiator can be employed singly or in combination of two or more kinds.

The photopolymerization initiator is preferably contained in an amount of 0.5 to 5.0 parts by weight based on 100 parts by weight of ethylene-vinyl acetate copolymer.

The light-receiving side sealing film and the backside colored sealing film may further contain a crosslinking auxiliary. The crosslinking auxiliary enables the enhancement of gel fraction of ethylene-vinyl acetate copolymer and the improvement of adhesion and durability of the sealing films.

The crosslinking auxiliary is preferably used in an amount of not more than 10 parts by weight, preferably 0.1 to 5 parts by weight, more preferably 0.1 to 2.5 parts by weight, based on 100 parts by weight of ethylene-vinyl acetate copolymer. The use of the crosslinking auxiliary can give sealing films having high adhesion.

Examples of the crosslinking auxiliary (compounds having radical polymerizable groups as functional groups) include trifunctional crosslinking auxiliaries such as triallyl cyanurate and triallyl isocyanurate, and mono- or bifunctional crosslinking auxiliaries of (meth)acryl esters (e.g., NK Ester, etc.). Among these, triallyl cyanurate and triallyl isocyanurate are preferred. Triallyl isocyanurate is particularly preferred.

It is preferred that the light-receiving side sealing film and the backside colored sealing film have high adhesion in view of sealing performance of the inside of a solar cell module. Thus the sealing films may each contain an adhesion improver. A silane coupling agent is used as the adhesion improver. The use of silane coupling agent can form sealing films having high adhesion. Examples of the silane coupling agents include γ-chloropropylmethoxysilane, vinyltriethoxysilane, vinyl-tris(β-methoxyethoxy)silane, γ-methacryloxypropyltrimethoxysilane, vinyltriacetoxysilane, γ-glycidoxypropyltrimethoxysilane, γ-glycidoxypropyltriethoxysilane, β-(3,4-epoxycyclohexyl)ethyltrimethoxysilane, vinyltrichlorosilane, γ-mercaptopropyltrimethoxysilane, γ-aminopropyltriethoxysilane and N-β-(aminoethyl)-y-aminopropyltrimethoxysilane. The silane coupling agent can be employed singly or in combination of two or more kinds. Particularly, γ-methacryloxypropyltrimethoxysilane is preferred.

The silane coupling agent is contained in an amount of not more than 5 parts by weight, preferably 0.1 to 2 parts by weight, based on 100 parts by weight of ethylene-vinyl acetate copolymer.

The backside colored sealing film used in the present invention contains a colorant. As the colorant, white colorants such as titanium white (titanium dioxide) and calcium carbonate; blue colorants such as ultramarine; black colorants such as carbon black; or milky white colorants such as glass beads and light diffusing agents can be used.

The colorant is preferably contained in an amount of 2 to 10 parts by weight, more preferably 3 to 6 parts by weight, based on 100 parts by weight of ethylene vinyl-acetate copolymer contained in the backside colored sealing film.

The light-receiving side sealing film and the backside colored sealing film can each contain, if necessary, various additives such as plasticizers, acryloxy group-containing compounds and/or methacryloxy group-containing compounds and/or epoxy group-containing compounds, and ultraviolet absorbers, light stabilizers and antioxidants, for improvement or adjustment of various properties of the films (e.g., mechanical strength, optical characteristics, heat resistance, light resistance and cross-linking rate).

The light-receiving side sealing film and the backside colored sealing film can be prepared according to known methods. The sealing films can be prepared, for example, by a process in which a composition comprising the above-mentioned materials is molded by using conventional extrusion molding or calendar molding (calendaring) to prepare a product in the form of sheet. Otherwise, the sealing films can be prepared by dissolving the above-mentioned composition in a solvent to form a solution, applying the solution onto an appropriate support by an appropriate coater and drying it to form a coated film (product in the form of sheet). The heating temperature in the film-formation is preferably selected such that the crosslinker is not reacted or scarcely reacted. For example, the heating temperature is preferably in the range of 50 to 90°C, especially 40 to 80°C.

### [Light-receiving side transparent protection material]

As the light-receiving side transparent protection material used in the present invention, a glass plate such as silicate glass can be used. The light-receiving side transparent protection material generally has a thickness of 0.1 to 10 mm, preferably 0.3 to 5 mm. The light-receiving side transparent protection material may be tempered in heat or chemical resistance.

### [Backside protection material]

As the backside protection material used in the present invention, a plastic film made of polyethylene telephthalate (PET) or polyamides is preferably used. The backside protection material may be a fluorinated polyethylene film, in particular a film obtained by laminating fluorinated polyethylene film /Al/ fluorinated polyethylene film in this order or a film obtained by laminating polyvinyl fluoride (trade name: Tedlar®) / PET / polyvinyl fluoride in this order, from the viewpoint of heat resistance and heat and humidity resistance.

### [Photovoltaic elements]

Photovoltaic elements used in the solar cell module act as photoelectric conversion, and used are conventionally known semiconductor substrates. The semiconductor substrates include, optical semiconductor elements composed of monocrystalline, polycrystalline or amorphous silicon, for example, amorphous silicon a-Si, hydrogenated amorphous silicon a-Si:H, hydrogenated amorphous silicon carbide a-SiC:H and amorphous silicon nitride, and also semiconductor layers obtained by composing amorphous crystal or microcrystal of amorphous crystal-based semiconductor composed of alloy of silicon and other element(s) such as carbon, germanium and tin, in the form of pin-type, nip-type, ni-type, pn-type, MIS-type, heterojunction-type, homojunction-type, schottky barrier-type or a combination thereof. In addition, the optical semiconductor elements may be those based on Cds, GaAs or InP or the like.

Photovoltaic elements are incorporated into a solar cell module by using conventionally known methods. For example, inner leads such as a copper foil applied by solder plating are connected to electrodes of photovoltaic elements, and then the photovoltaic elements are connected to each other by the inner leads in series-parallel so as to take out a certain amount of electric output from solar cell modules.

### [Applying heat and pressure step]

The applying heat and pressure step in the process of the present invention is explained below.

In the process of the present invention, the stack described above is pressurized while heating. In the present invention, a method of pressurizing and heating the stack is not particularly limited but preferably carried out by using, for example, a vacuum laminator provided with a expandable diaphragm, particularly a double vacuum chamber-type laminator shown in Fig. 2.

The vacuum laminator 100 shown in Fig. 2 has an upper chamber 102 provided with a diaphragm 103 and a lower chamber 101 provided with a placement base 105 for placing the stack 10. In the vacuum laminator 100, after the upper chamber 102 and the lower chamber 101 are evacuated, the stack 10 is pressurized by the diaphragm 103. The evacuation of the upper chamber 102 and the lower chamber 101 is carried out by a lower chamber vacuum pump 107 connected to an lower chamber outlet 106 and a upper chamber vacuum pump 109 connected to an upper chamber outlet 108.

In order to apply pressure to the stack 10 by using the vacuum laminator 100, firstly, a light-receiving side transparent protection material 11, a light-receiving side sealing film 13A, photovoltaic elements 14, a backside colored film 13B and a backside protection material 12 are superposed in this order on the placement base 105 provided inside the lower chamber 101 to give the stack 10. Subsequently, after the upper chamber 102 and the lower chamber 101 are depressurized by the upper chamber vacuum pump 109 and the lower chamber vacuum pump 107 to evacuate them, the pressure in the upper chamber 102 is set preferably to atmospheric pressure or higher.

The evacuation of the upper chamber 102 and the lower chamber 101 is preferably carried out by depressurizing the upper chamber 102 and the lower chamber 101 to a pressure of 50 to 150 Pa, particularly 50 to 100 Pa. The evacuation time is, for example, from 0.1 to 5 minutes. Subsequently, the pressure in the upper chamber 102 is set to a pressure of 40 to 110 kPa, particularly 60 to 105 kPa, to pressurize the stack 10 uniformly by the diaphragm 103.

The expansion degree of the diaphragm 103 is preferably adjusted such that the stack 10 is pressurized at a pressure of 1.0×10³ Pa to 5.0×10⁷ Pa, particularly 60 to 105 kPa. The pressing time is, for example, from 5 to 15 minutes.

In the process of the present invention, the stack 10 is heated while pressurizing. The heating is performed, for example, by placing the whole vacuum laminator 100 shown in Fig. 2 in a high temperature environment such as an oven to heat the stack 10, or by installing a heating medium such as a heating plate into the lower chamber 101 of the vacuum laminator 100 shown in Fig. 2 to heat the stack 10. The latter method is carried out, for example, by using a heating plate as the placement base 105, by arranging heating plate(s) above and/or below the placement base 105, or by arranging heating plate(s) above and/or below the stack 10.

Of these heating methods, it is preferred that a heating plate is used as the placement base 105 and heat is applied to the side of the light-receiving side transparent protection material 11 of the stack 10. In this method, heat transfer to the light-receiving side sealing film 13A is achieved earlier, and thus the adhesion of the light-receiving side sealing film 13A to the photovoltaic elements 14 is further enhanced, thereby preventing the wraparound of the backside colored sealing film 13B.

The stack 10 is preferably heated to a temperature of 80 to 150°C, particularly 90 to 145°C. The heating time may be from 10 minutes to 1 hour. The stack 10 is more preferably heated in a stepwise fashion by preheating the stack 10 at a temperature of 80 to 120°C, and then heating the stack 10 at a temperature of 100 to 150°C, particularly about 130°C.

The pressurization and heating of the stack is preferably carried out by heating the stack to the above-mentioned temperature together with evacuating the vacuum laminator, and then expanding the diaphragm.

In the present invention, since the light-receiving side sealing film having a thickness less than that of the backside colored sealing film, and the backside colored sealing film having a thickness more than that of the light-receiving side sealing film are used, in the applying heat and pressure step, the light-receiving side sealing film to which heat is transferred earlier is well bonded to photovoltaic elements and the stack can be pressurized uniformly. This results in preventing the backside colored sealing film from wrapping around to the light-receiving side of photovoltaic elements.

### Examples

The invention is illustrated in detail using the following Examples.

### [Examples 1-28, Comparative Examples 1-16]

### 1. Preparation of a light-receiving side sealing film

The materials of the formulation set forth below were introduced into a roll mill and kneaded at 70°C to prepare a composition for a light-receiving side sealing film. The composition was subjected to calendaring processing at 70°C and then cooled to give a light-receiving side sealing film (230 mm×230 mm) having a thickness shown in Figs 1 to 5.

### (Formulation)

- Ethylene-vinyl acetate copolymer (the content of vinyl acetate: 26% by weight, MFR: 4.3 g/10 min) 100 parts by weight
- Crosslinker (2,5-dimethyl-2,5-di(t-butylperoxy)hexane, PERHEXA 25B available from NOF Corporation) 1.3 parts by weight
- Crosslinking auxiliary (triallyl isocyanurate, TAIC available from Nippon Kasei Chemical Co., Ltd) 1.5 parts by weight
- Silane coupling agent (γ-methacryloxypropyltrimethoxysilane, KBM 503 available from Shin-Etsu Chemical Co., Ltd.) 0.5 parts by weight

### 2. Preparation of a backside colored sealing film

The materials of the formulation set forth below were introduced into a roll mill and kneaded at 70°C to prepare a composition for a backside colored sealing film. The composition was subjected to calendaring processing at 70°C and then cooled to give a backside colored sealing film (230 mm×230 mm) having a thickness shown in Figs 1 to 5.

### (Formulation)

- Ethylene-vinyl acetate copolymer (the content of vinyl acetate: 26% by weight, MFR: 4.3 g/10 min) 100 parts by weight
- Crosslinker (2,5-dimethyl-2,5-di(t-butylperoxy)hexane, PERHEXA 25B available from NOF Corporation) 1.3 parts by weight
- Crosslinking auxiliary (triallyl isocyanurate, TAIC available from Nippon Kasei Chemical Co., Ltd) 1.5 parts by weight
- Silane coupling agent (γ-methacryloxypropyltrimethoxysilane, KBM 503 available from Shin-Etsu Chemical Co., Ltd.) 0.5 parts by weight
- Colorlant (titanium dioxide) 5 parts by weight

### 3. Manufacture of a solar cell module

A light-receiving side transparent protection material (white sheet tempered glass with emboss) / the above-mentioned light-receiving side sealing film / photovoltaic elements (monocrystal silicon cells: 125mm × 125 mm, thickness: 220 µm) / the above-mentioned backside colored sealing film / a backside protection material (TPT (Tedlar®/PET/ Tedlar®), model number: 2442, available from Isovolta AG, thickness: 350 µm) were superposed in this order to give a stack. The individual components of the stack were bonded and integrated by using a double chamber-type vacuum laminator provided with a diaphragm under conditions of a temperature of 145°C, an evacuation time of 5 minutes, a pressure of 0.1 MPa and a pressing time of 15 minutes, to give a solar cell module.

### [Evaluation methods]

### Measurement of wraparound degree

A wraparound degree when the backside colored sealing film was wrapped around to the light-receiving side of the photovoltaic elements of the obtained solar cell module was measured. The wraparound degree was measured by gauging a length (mm) from the edge of the photovoltaic element to a position to which the backside colored sealing film was the most wrapped around the photovoltaic element by using a scale.

The results are shown in Tables 1 to 5.

**Table 1**

| | Ex. 1 | Ex. 2 | Ex. 3 | Ex. 4 | Ex. 5 | Ex. 6 | Ex. 7 | Ex. 8 | Ex. 9 | Ex. 10 |
|---|---|---|---|---|---|---|---|---|---|---|
| Thickness of light-receiving side sealing film (mm) | 0.40 | 0.40 | 0.40 | 0.40 | 0.40 | 0.30 | 0.30 | 0.30 | 0.30 | 0.30 |
| Thickness of backside colored sealing film (mm) | 1.20 | 1.00 | 0.90 | 0.80 | 0.70 | 1.20 | 1.00 | 0.90 | 0.80 | 0.70 |
| Thickness ratio of backside colored sealing film/light-receiving side sealing film | 3.0 | 2.50 | 2.25 | 2.00 | 1.75 | 4.00 | 3.33 | 3.00 | 2.67 | 2.33 |
| Thickness difference between backside colored sealing film and light-receiving side sealing film (mm) | 0.80 | 0.60 | 0.50 | 0.40 | 0.30 | 0.90 | 0.70 | 0.60 | 0.50 | 0.40 |
| Wraparound degree (mm) | 0.0 | 0.0 | 0.0 | 0.0 | 0.0 | 0.0 | 0.0 | 0.0 | 0.0 | 0.0 |

**Table 2**

| | Ex. 11 | Ex. 12 | Ex. 13 | Ex. 14 | Ex. 15 | Ex. 16 | Ex. 17 | Ex. 18 | Ex. 19 |
|---|---|---|---|---|---|---|---|---|---|
| Thickness of light-receiving side sealing film (mm) | 0.50 | 0.50 | 0.50 | 0.50 | 0.50 | 0.55 | 0.55 | 0.55 | 0.55 |
| Thickness of backside colored sealing film (mm) | 1.20 | 1.00 | 0.90 | 0.80 | 0.70 | 1.20 | 1.00 | 0.90 | 0.80 |
| Thickness ratio of backside colored sealing film/light-receiving side sealing film | 2.40 | 2.00 | 1.80 | 1.60 | 1.40 | 2.18 | 1.82 | 1.64 | 1.45 |
| Thickness difference between backside colored sealing film and light-receiving side sealing film (mm) | 0.70 | 0.50 | 0.40 | 0.30 | 0.20 | 0.65 | 0.45 | 0.35 | 0.25 |
| Wraparound degree (mm) | 0.0 | 0.0 | 0.0 | 0.0 | 0.0 | 0.0 | 0.0 | 0.0 | 0.0 |

**Table 3**

| | Ex. 20 | Ex. 21 | Ex. 22 | Ex. 23 | Ex. 24 | Ex. 25 | Ex. 26 | Ex. 27 | Ex. 28 |
|---|---|---|---|---|---|---|---|---|---|
| Thickness of light-receiving side sealing film (mm) | 0.40 | 0.40 | 0.40 | 0.40 | 0.30 | 0.30 | 0.30 | 0.50 | 0.55 |
| Thickness of backside colored sealing film (mm) | 0.65 | 0.60 | 0.55 | 0.50 | 0.65 | 0.60 | 0.55 | 0.65 | 0.70 |
| Thickness ratio of backside colored sealing film/light-receiving side sealing film | 1.63 | 1.50 | 1.38 | 1.25 | 2.17 | 2.00 | 1.83 | 1.30 | 1.27 |
| Thickness difference between backside colored sealing film and light-receiving side sealing film (mm) | 0.25 | 0.20 | 0.15 | 0.10 | 0.35 | 0.30 | 0.25 | 0.15 | 0.15 |
| Wraparound degree (mm) | 0.2 | 0.2 | 0.40 | 0.50 | 0.7 | 0.4 | 0.55 | 0.4 | 0.5 |

**Table 4**

| | Co. Ex. 1 | Co. Ex. 2 | Co. Ex. 3 | Co. Ex. 4 | Co. Ex. 5 | Co. Ex. 6 | Co. Ex. 7 | Co. Ex. 8 |
|---|---|---|---|---|---|---|---|---|
| Thickness of light-receiving side sealing film (mm) | 0.40 | 0.40 | 0.30 | 1.00 | 1.00 | 1.00 | 1.00 | 0.80 |
| Thickness of backside colored sealing film (mm) | 0.30 | 0.40 | 0.30 | 0.40 | 0.50 | 0.80 | 0.90 | 0.40 |
| Thickness ratio of backside colored sealing film/light-receiving side sealing film | 0.75 | 1.00 | 1.00 | 0.40 | 0.50 | 0.80 | 0.90 | 0.50 |
| Thickness difference between backside colored sealing film and light-receiving side sealing film (mm) | -0.10 | 0 | 0 | -0.60 | -0.5 | -0.20 | -0.10 | -0.40 |
| Wraparound degree (mm) | 1.2 | 1.0 | 1.5 | 1.3 | 1.0 | 1.7 | 3.3 | 1.5 |

**Table 5**

| | Co. Ex. 9 | Co. Ex. 10 | Co. Ex. 11 | Co. Ex. 12 | Co. Ex. 13 | Co. Ex. 14 | Co. Ex. 15 | Co. Ex. 16 |
|---|---|---|---|---|---|---|---|---|
| Thickness of light-receiving side sealing film (mm) | 0.80 | 0.80 | 0.80 | 0.60 | 0.60 | 0.60 | 0.50 | 0.50 |
| Thickness of backside colored sealing film (mm) | 0.50 | 0.60 | 0.80 | 0.40 | 0.50 | 0.60 | 0.40 | 0.50 |
| Thickness ratio of backside colored sealing film/light-receiving side sealing film | 0.63 | 0.75 | 1.00 | 0.67 | 0.83 | 1.00 | 0.80 | 1.00 |
| Thickness difference between backside colored sealing film and light-receiving side sealing film (mm) | -0.30 | -0.20 | 0 | -0.20 | -0.10 | 0 | -0.10 | 0 |
| Wraparound degree (mm) | 2.0 | 1.5 | 2.0 | 1.0 | 1.7 | 1.7 | 1.0 | 2.0 |

### [Evaluation results]

As shown in the Tables, in case where the thickness of the light-receiving side sealing film is less than that of the backside colored sealing film, the wraparound degree is reduced. In particular, when the thickness ratio is from 1.60 to 3.00 and/or the thickness difference is from 0.50 to 0.90 mm, the wraparound is markedly suppressed.

### Industrial Applicability

The process for manufacturing a solar cell module of the present invention enables prevention of wraparound of a backside colored sealing film, and thus provision of solar cell modules which are prevented from reduction in appearance properties and in power generation efficiency.

### Description of reference number

- 10: Stack
- 11: Light-receiving side transparent protection material
- 12: Backside protection material
- 13A: Light-receiving side sealing film
- 13B: Backside colored sealing film
- 14: Photovoltaic element
- 15: Connection tab
- 100: Vacuum laminator
- 101: Lower chamber
- 102: Upper chamber
- 103: Diaphragm
- 105: Placement base
- 106: Lower chamber outlet
- 107: Lower chamber vacuum pump
- 108: Upper chamber outlet
- 109: Upper chamber vacuum pump

## Claims

1. A process for manufacturing a solar cell module, comprising superposing a light-receiving side transparent protection material, a light-receiving side sealing film, photovoltaic elements, a backside colored sealing film and a backside protection material in this order to give a stack, and applying heat and pressure to the stack to integrate it,
wherein the light-receiving side sealing film has a thickness less than that of the backside colored sealing film.

2. The process according to claim 1, wherein the light-receiving side sealing film has a thickness of 0.3 to 0.55 mm.

3. The process according to claim 1 or 2, wherein the backside colored sealing film has a thickness of 0.55 to 1.2 mm.

4. The process according to any one of claims 1 to 3, wherein a ratio of the thickness of the backside colored sealing film to that of the light-receiving side sealing film is in the range of 1.25 to 3.00.

5. The process according to any one of claims 1 to 4, wherein heat is applied to the side of the light-receiving side transparent protection material.

6. The process according to any one of claims 1 to 5, wherein the stack is heated to a temperature in the range of 80 to 150°C.

7. The process according to any one of claims 1 to 6, wherein pressure of 1.0×10³ Pa to 5.0×10⁷ Pa is applied to the stack.

8. The process according to any one of claims 1 to 7, wherein the light-receiving side sealing film and the backside colored sealing film each comprise ethylene-vinyl acetate copolymer and a crosslinker.

9. The process according to any one of claim 1 to 8, wherein the backside colored sealing film comprises a colorant selected from the group consisting of titanium dioxide, calcium carbonate, ultramarine and carbon black.

10. A solar cell module obtained by arranging sealing films between a light-receiving side transparent protection material and a backside protection material and bonding and integrating them to seal photovoltaic elements,
wherein a light-receiving side sealing film arranged between the photovoltaic elements and the light-receiving side transparent protection material has a thickness less than that of a backside colored sealing film arranged between the photovoltaic elements, and the backside protection material.
